# EUROPÄISCHE PATENTSCHRIFT

(11) **EP 3 887 714 B1**
(45) Veröffentlichungstag und Bekanntmachung des Hinweises auf die Patenterteilung: **29.05.2024**
(21) Anmeldenummer: 19812721.9
(22) Anmeldetag: 19.11.2019
(51) Int. Cl.: F21S 41/143, F21S 41/147, F21S 41/153, F21S 45/48, F21V 29/503, F21V 29/76, F21V 29/89, F21Y 115/10, H01L 33/62, H01L 33/64, H05K 1/02, H05K 1/18, H05K 3/00, H05K 3/10

(54) **ELEKTROOPTISCHE BAUGRUPPE MIT WÄRMEABFÜHRUNG SOWIE VERFAHREN ZUR HERSTELLUNG EINER SOLCHEN BAUGRUPPE**
ELECTRO-OPTICAL ASSEMBLY HAVING HEAT DISSIPATION, AND METHOD FOR PRODUCING SUCH AN ASSEMBLY
COMPOSANT OPTOÉLECTRONIQUE AVEC DISSIPATION DE CHALEUR, ET PROCÉDÉ DE FABRICATION D'UN TEL COMPOSANT

(30) Priorität: 26.11.2018 DE 102018009292
(43) Veröffentlichungstag der Anmeldung: 06.10.2021
(73) Patentinhaber: Harting AG, 2500 Biel 6 (CH)
(72) Erfinder: SPIRG, Michael, 2500 Biel 6 (CH)
(74) Vertreter: Prinz & Partner mbB
(86) Internationale Anmeldenummer: PCT/EP2019/081813
(87) Internationale Veröffentlichungsnummer: WO 2020/109086

(56) Entgegenhaltungen:
- EP-A1- 3 116 038
- EP-A2- 1 156 708
- WO-A1-00/28362
- WO-A2-03/005784
- DE-A1-102010 033 093
- DE-A1-102015 105 470
- DE-U1- 20 302 873
- KR-A- 20170 124 732
- US-A1- 2009 114 937
- US-A1- 2012 092 833
- US-A1- 2017 343 204

## Beschreibung

Die Erfindung betrifft eine elektrooptische Baugruppe nach der Gattung des unabhängigen Anspruchs 1.

Weiterhin geht die Erfindung aus von einem Verfahren zur Herstellung einer elektrooptischen Baugruppe gemäß der Gattung des unabhängigen Anspruchs 11.

Eine derartige Baugruppe ist zweckmäßig, um beispielsweise LEDs (Licht Emittierende Diode/ Light Emitting Diodes), insbesondere leistungsstarke LEDS, in Verbindung mit der MID (Molded Interconnect Device) -Technologie individuell auszurichten. MIDs können dabei als Formteile mit einer integrierten Leiterbahnenstruktur verstanden werden.

Eine derartige Baugruppe ist gleichermaßen zweckmäßig, um beispielsweise bei einer räumlich spritzgegossenen Grundplatte oder Trägerplatte (MID-Teil) externe oder interne Signale oder eine Strom- und/oder Spannungsversorgung mit einer lösbaren Kontaktierung abzugreifen oder zuzuführen.

### Stand der Technik

Im Stand der Technik ist aus der Druckschrift WO 00/28362 A1 eine elektrooptische Baugruppe sowie ein Verfahren zur Herstellung einer solchen Baugruppe bekannt. So ist es aus der genannten Druckschrift bekannt in einer Trägerplatte eine Metallschicht am Boden einer Vertiefung für die Aufnahme eines elektrooptischen Elements, beispielsweise einer LED, als Kühlkörper auszubilden.

Der Einsatz von spritzgegossenen Trägerplatten mit einer räumlichen Ausrichtung (3D) einzelner elektrooptischer Bauteile, wie beispielsweise LEDs, insbesondere leistungsstarker LEDs, wird von immer größerer Bedeutung. Derartig spritzgegossene Trägerplatten bieten den Vorteil komplexer 3D-Bauteil-Geometrien, die auch dreidimensionale Leiterbahn-Strukturen vollständig integrieren. So können etwa Leiterbahnen auf mehreren Bauteilebenen partiell miteinander verbunden werden. Das Anwendungsgebiet von leistungsstarken LEDs in Verbindung mit der MID-Technologie zu einer individuellen Ausrichtung der einzelnen LEDs ist sehr breit. Beispielhaft aber nicht einschränkend seien erwähnt, die Automobilscheinwerfer sowie Automobilrückleuchten, Außen- und Innenbeleuchtungen aller Art sowie Kamerabeleuchtungen.

Ein wesentlicher Punkt bei der Nutzung der MID-Technologie ist die Zusammenführung mechanischer und elektrischer Funktionen in einem Bauteil, wobei hier durch eine Reduzierung der Einzelteile der Montageaufwand gesenkt und die Prozesskette verkürzt wird, was zu einer Verringerung der Fertigungskosten und einer Verkleinerung der elektronischen Baugruppen führt.

Alternativ oder ergänzend dazu kann die Grundplatte mittels einer so genannten Metal Plated Frame Implementation ausgebildet sein. Auch hier wird die Grundplatte vorzugsweise in einem Spritzgussverfahren hergestellt. Das Verfahren der Metal Plated Frame Implementation ist ausführlich in dem Dokument WO 2011/157515 A1 beschrieben.

Zusätzlich lassen sich beispielsweise funktionsfähige Stromdurchführungen durch das Galvanisieren von Bohrungen herstellen, was mit herkömmlichem Laser-Strukturieren bislang nicht möglich ist. Damit können häufig aus mehreren Bauteilen bestehende Baugruppen durch Produkte ersetzt werden, die in einem vergleichsweise einfachen und schnellen zweistufigen Fertigungsverfahren entstehen, wobei sich das Fertigungsverfahren aus Spritzgießen und dem nachgeordneten Galvanisieren zusammensetzt. In Verbindung mit der Gestaltungsfreiheit im Bauteil-Design ist diese Methode verglichen mit der bisherigen Herstellung häufig kostengünstiger. So entstehen etwa anspruchsvolle Mechatronik-Systeme für Anwendungen im Automobilbau, in der Medizintechnik, im Telekommunikations- sowie im Elektronikbereich, die mechanische und elektrische Eigenschaften auf engstem Raum vereinen.

Auch die Nutzung von hochtemperatursicheren Thermoplasten und deren strukturierbare Metallisierung ist denkbar, welche neue Dimensionen von Grundplatten ermöglicht.

Für MID-Bauteile mit Kunststoff als Trägermaterial ist das zuverlässige Ableiten von Wärme bislang problematisch, wobei die Wärme insbesondere durch elektrooptische Bauteile erzeugt wird. Die erzeugte Wärme, die insbesondere durch Verwendung vom Hochleistungs-LEDs entsteht, führt zu einem Verformen und langfristigen Deformieren der Kunststoff-Trägerplatte, so dass eine Langlebigkeit der Baugruppe nicht zu gewährleisten ist. Die erzeugte und nicht abgeführte Wärme kann weiterhin zur Folge haben, dass das elektrooptische Bauteil durchbrennt und/oder schmilzt und somit nur eine kurzlebige Funktionsfähigkeit aufweist.

Die EP 3 116 038 A1 offenbart ein Lichtquellenmodul mit einer Lichtquelle und einem Körper, welcher die Lichtquelle trägt, wobei der Körper eine Wärmesenke umfasst, die Wärme von der Lichtquelle absorbiert und in die Umgebung freigibt.

Die WO 03/005784 A2 beschreibt ein Verfahren zur Herstellung von Leiterbahnstrukturen auf einem elektrisch nichtleitenden Trägermaterial, die aus Metallkeimen und einer nachfolgend auf diese aufgebrachte Metallisierung bestehen, wobei die Metallkeime durch Aufbrechen von feinstverteilt in dem Trägermaterial enthaltenen elektrisch nichtleitenden Metallverbindungen durch elektromagnetische Strahlung entstanden sind.

US 2017/0343204 A1 offenbart eine Beleuchtungsvorrichtung, die eine Fassung, eine Vielzahl von lichtemittierenden Elementen, eine lichtdurchlässige Abdeckung und eine Lampensockelstruktur umfasst. Die Halterung umfasst einen wärmeableitenden Grundkörper und eine Trägereinheit. Die Trägereinheit umfasst einen Basiskörper, ein Schaltungsmuster und ein wärmeableitendes Muster, wobei das Schaltungsmuster und das wärmeableitende Muster direkt an einer Oberfläche des tragenden Basiskörpers ausgebildet sind. Das wärmeableitende Muster erstreckt sich zumindest von einem Bereich nahe der Montageposition zu einem Bereich, in dem das wärmeableitende Muster den wärmeableitenden Basiskörper kontaktieren kann.

DE102010033093 A1 offenbart eine elektrooptische Baugruppe mit einem spritzgegossenen Schaltungsträger (MID), der einen Träger in lateraler Richtung ringsum vollständig und formschlüssig umgibt. Auf einer Trägeroberseite befinden sich optoelektronische Halbleiterchips.

### Aufgabenstellung

Der Erfindung liegt die Aufgabe zugrunde, eine (Bauform für eine) Baugruppe für zumindest eine Grundplatte anzugeben, die eine Überhitzung vermeidet, so dass die Grundplatte und/oder das elektrooptische Element möglichst frei von Wärme und langfristiger Zerstörung bleibt.

Diese Aufgabe wird durch die Merkmale der unabhängigen Ansprüche gelöst.

Eine Baugruppe besteht aus zumindest einer Grundplatte, einer damit verbundenen Gegenplatte und einem elektrooptischen Element. Die Grundplatte ist mit mindestens einer Leiterbahn für einen Anschluss des elektrooptischen Elements und mindestens einem Wärmeübertragungselement für eine Wärmeabführung von dem elektrooptischen Element versehen. Das Wärmeübertragungselement stellt eine direkte wärmeleitende Wirkverbindung zwischen dem elektrooptischen Element und der Gegenplatte her. Die Grundplatte sieht eine Aufnahme für das Wärmeübertragungselement vor. Es ist sinnvoll die Aufnahme für das Wärmeübertragungselement in Form einer Aufnahmeöffnung auszugestalten.

Die mit der Erfindung erzielten Vorteile bestehen insbesondere darin, dass durch Einführen der Wirkverbindung von dem wärmeproduzierenden Bereich zu einem Kühlbereich eine sehr langlebige Baugruppe realisierbar ist.

Von besonderem Vorteil ist es dabei, dass mit der Erfindung auf gleichem Bauraum mit gleicher elektrischer Energie mehr Lichtstärke - oder anders formuliert, mit weniger elektrischer Energie die gleiche Lichtstärke - erzeugbar ist. Mit anderen Worten lässt sich durch die erfindungsgemäße Wärmeableitung der Wirkungsgrad der LEDs erheblich verbessern. Diese Wirkungsgradverbesserung kann beispielsweise für LED-Baugruppen mit einer autarken Stromversorgung, z.B. durch Solarzellen mit elektrischem Energiespeicher, von besonderes großem Vorteil sein.

Schließlich würde ohne die erfindungsgemäße Lösung eine Erwärmung der LED zu einem schlechteren Wirkungsgrad derselben führen. Dies würde bedeuten, dass zur Erzeugung derselben Lichtstärke ein höheres Maß an elektrischer Energie notwendig wäre. Dies hätte wiederum eine noch größere Erwärmung der LED zur Folge, würde also in Form einer Kettenreaktion sowohl den Energieverbrauch erhöhen als auch die Lebensdauer der LED erheblich verringern. Einer solchen, daher höchst unerwünschten Kettenreaktion wird durch die Erfindung besonders vorteilhaft entgegengewirkt.

Ein weiterer Vorteil der Erfindung kann die Realisierung einer sehr kostengünstigen steckbaren Verbindung eines Steckverbinders zu einer räumlich spritzgegossenen Grundplatte (3D-MID) sein.

Gemäß einer bevorzugten Ausgestaltungsform ist die Grundplatte aus einem Kunststoffmaterial gebildet.

In der erfindungsgemäßen Ausgestaltung ist die Grundplatte ein spritzgegossenes Bauteil, insbesondere ein MID-Bauteil. Und in einer besonders bevorzugten Ausgestaltung ist das spritzgegossene MID-Bauteil in einem 2K (2-Komponenten) -Verfahren und/oder in einem LDS (Laser-Direkt-Strukturierung) - Verfahren hergestellt.

Die Grundplatte kann demnach eine spritzgegossener, dreidimensionaler (3D) Trägerplatte aus zumindest einer Kunststoffkomponente sein. Eine Trägerplatte, welche in einem Spritzguss-Verfahren hergestellt ist, bietet den Vorteil komplexer 3D-Bauteil-Geometrien. Dabei ist es ebenfalls einfach realisierbar, dreidimensionale Leiterbahn-Strukturen zu integrieren. So können mehr als eine Leiterbahn auf mehr als einer Ebene der Trägerplatte partiell miteinander verbunden sein. Die vergleichsweise schnelle, einfache und sehr individuelle Ausgestaltungsmöglichkeit solcher spritzgegossenen Bauteile bietet ferner eine Lösung für Raumproblematiken. Damit können häufig aus mehreren Bauteilen bestehende sperrige Baugruppen durch flexibel gestaltbare, kompakte Produkte ersetzt werden. Ein solches Fertigungsverfahren für ein MID-Bauteil ist folglich an jeweilige geometrische Anforderungen, beispielsweise Anforderungen an Leiterbahnen oder elektrooptischer Elemente, flexibel und individuell anpassbar. Ein elektrooptisches Element kann beispielsweise ein LED-Leuchtmittel, insbesondere ein Hochleistungs-LED-Leuchtmittel, sein. Aber auch Glühbirnen und andere Leuchtmittel sind eingeschlossen.

In einer besonders bevorzugten Ausgestaltung ist die Gegenplatte ein Kühlkörper. Erfindungsgemäß ist die Gegenplatte ein Metallteil. Es ist vorstellbar, dass die Gegenplatte eine Gehäuseplatte und/oder eine Gehäusewand ist, an welche die Baugruppe befestigt wird. Dies ist von besonderem Vorteil, da die erfindungsgemäße Baugruppe auch nachträglich an ein bereits existierendes Gehäuse anbringbar ist. Es ist dann nicht notwendig, in der erfindungsgemäßen Baugruppe eine weitere Gegenplatte vorzusehen.

Die Gegenplatte kann ein Stanzteil sein. Beispielsweise kann die Gegenplatte ein ausgestanztes Metallblechteil sein, insbesondere ein einstückig ausgestanztes Metallblechteil. Beispielsweise kann die Gegenplatte ein ausgestanztes Stahlblechteil sein, insbesondere ein einstückig ausgestanztes Stahlblechteil. Es ist allerdings nicht ausgeschlossen die Gegenplatte beispielsweise aus einem keramischen Werkstoff auszugestalten.

In einer besonders bevorzugten Ausgestaltung ist die Gegenplatte aus einem Wärmeleiter-Material, und erfindungsgemäß aus einem Metall, ausgebildet. Auch ist eine Kombination aus verschiedenen wärmeleitfähigen Metallen denkbar. Es ist ferner denkbar die Gegenplatte in allen geometrisch denkbaren Gestalten auszubilden. So kann die Gegenplatte je nach Anforderung an den Bauraum und je nach Leistung des elektrooptischen Elements und damit je nach produzierter Wärmemenge eine entsprechende Kühlfläche und/oder ein entsprechendes Kühlvolumen für die Wärmeaufnahme und/oder für die Wärmeabfuhr aufweisen. Insbesondere kann die Größe der Kühlfläche und/oder das Volumen der Gegenplatte entsprechend einer produzierten Wärmemenge durch ein elektrooptisches Element ausgebildet sein. So ist es sinnvoll eine wärmeleitende Gegenplatte mit einer großen Oberfläche für eine schnelle Wärmeaufnahme und/oder eine schnelle Wärmeabfuhr für elektrooptische Elemente mit hoher Leistung oder hoher Wärmeproduktion vorzusehen.

In einer weiteren vorteilhaften Ausgestaltung weist die Gegenplatte Kühlrippen und/oder Kühlfinger und/oder Kühlstifte auf. Eine solche Ausgestaltungsform erzielt eine große Kühlfläche der Gegenplatte bei einer kleinen Baugröße.

Das Wärmeübertragungselement führt produzierte Wärme am elektrooptischen Element ab und leitet die Wärme an die Gegenplatte weiter. Erfindungsgemäß ist gewährleistet das Wärmeübertragungselement eine direkte Wirkverbindung zwischen dem elektrooptischen Element und der Gegenplatte. Es ist vorteilhaft das Wärmeübertragungselement unmittelbar am wärmeproduzierenden elektrooptischen Element vorzusehen. Insbesondere ist es sinnvoll das Wärmeübertragungselement zumindest partiell mit dem elektrooptischen Element zu verbinden und/oder das Wärmeübertragungselement zumindest partiell mit der Gegenplatte zu verbinden.

Derart ist die produzierte Wärmemenge vom elektrooptischen Element mittels des Wärmeübertragungselements optimal auf die Gegenplatte übertragbar. Die erzeugte Wärmemenge ist folglich mittels des Wärmeübertragungselements von der Kunststoff-Grundplatte optimal wegleitbar. Auch hohe Wärmemengen von beispielsweise Hochleistungs-LEDs können derart mittels des Wärmeübertragungselements abgeleitet werden, so dass die Kunststoff-Grundplatte und/oder das elektrooptische Element unbeschadet bleibt und in ihrer Funktion langlebig ist.

Gemäß einer besonders bevorzugten Ausgestaltung ist das Wärmeübertragungselement ein Metalleinsatz, insbesondere ein Metallstift. Es ist sinnvoll das Wärmeübertragungselement als ein wärmeleitfähiges Material, insbesondere Metall, auszubilden. Auch ist eine Kombination aus verschiedenen wärmeleitfähigen Metallen denkbar. In einer sinnvollen Ausgestaltung ist der Metallstift quaderförmig ausgebildet. Ein quaderförmiger Metallstift weist vorteilhafterweise jeweils eine große Kontaktfläche für ein Kontaktieren des elektrooptischen Elements sowie für ein Kontaktieren der Gegenplatte auf. Ergänzend hat die quaderförmige Ausgestaltung des Metallstiftes eine kürzeste Wirkverbindung zur kühlenden Gegenplatte. Ebenfalls ist ein quaderförmiger Stift einfach in seiner Herstellung ausstanzbar.

In einer weiteren Ausgestaltungsmöglichkeit ist das Wärmeübertragungselement senkrecht zur einer ersten Grundplattenebene und senkrecht zur entgegengesetzten zweiten Grundplattenebene in der Grundplatte aufgenommen. Vorteilhafterweise ist derart eine minimale Länge der Wirkverbindung zwischen dem Wärmeübertragungselement und dem Kühlkörper geschaffen. Somit ist auch die produzierte Wärmemenge auf kürzestem Wege vom elektrooptischen Element über das Wärmeübertragungselement zum Kühlkörper abgeleitet und die Grundplatte und/oder das elektrooptische Element bleiben frei von wärmeinduzierten Schäden.

Um einen geringeren Wärmeverlust an Übergangsstellen zwischen dem Wärmeübertragungselement und der Gegenplatte zu realisieren ist es denkbar das Wärmeübertragungselement und die Gegenplatte einstückig auszubilden. Es ist ferner denkbar ein derart einstückig ausgebildetes Kühlbauteil aus demselben Material auszubilden. Beispielsweise ist es denkbar ein Stanzblech als Gegenplatte vorzusehen. Es ist sinnvoll aus dem Stanzblech zumindest ein, bevorzugt zwei und besonders bevorzugt mehr als zwei Wärmeübertragungselemente heraus zu biegen. Derart ist auf einfache und kostengünstige Weise eine einstückig ausgebildete Gegenplatte mit einem Wärmeübertragungselement realisiert. Das Stanzblech ist beispielsweise ein aus Messing gestanztes Blech.

In einer besonders bevorzugten Ausgestaltung ist es vorgesehen, dass die Aufnahme für das Wärmeübertragungselement eine Aufnahmenut ist, welche sich von dem elektrooptischen Element zur Gegenplatte erstreckt, insbesondere eine senkrecht zur der ersten Grundplattenebene und senkrecht zur entgegengesetzten zweiten Grundplattenebene verlaufende Aufnahmenut ist. Eine senkrecht zur jeweiligen Gegenplattenebene verlaufende Aufnahmenut hat den Vorteil, dass die Grundplatte eine kürzeste Verbindung von dem elektrooptischen Element zu der Gegenplatte aufweist. Bevorzugt ist die Aufnahmenut eine Hohlform in Gestalt eines Quaders. Eine derartige Ausgestaltung ermöglicht bevorzugt ein formschlüssiges Aufnehmen des ebenfalls quaderförmig ausgestalteten Metallstiftes. Das Abführen der produzierten Wärme weg von der Grundplatte hin zur kühlenden Gegenplatte ist dann optimal über das Wärmeübertragungselement realisiert.

Es ist vorteilhaft, dass die Aufnahme eine ausgestanzte Ausnahme ist. Das Ausstanzen der Aufnahme aus der im Spritzguss-Verfahren hergestellten Gegenplatte hat den Vorteil einer flexiblen Ausgestaltungsform, je nach gewünschten Anforderungen.

Eine weitere Ausgestaltungsmöglichkeit kann vorsehen eine Wärmeleitpaste und/oder eine Wärmeleitfolie in die Aufnahmenut für das Wärmeübertragungselement einzubringen. Die Wärmeleitpaste und/oder Wärmeleitfolie wird derart in die Aufnahmenut eingebracht, dass ein formschlüssiges Anbinden des Wärmeübertragungselements in der Aufnahmenut realisiert ist. Es werden auf diese Weise Lufteinschlüsse und/oder Luftspalte verhindert, die ein Wärmeabführen behindern. Als Wärmeleitpaste kann beispielsweise ein Phasenwechselmaterial vorgesehen sein. Es hat sich gezeigt, dass derart eine optimale Wärmeabführung realisiert ist.

In einer alternativen besonders bevorzugten Ausgestaltung ist es vorgesehen, dass die Aufnahme für das Wärmeübertragungselement eine Aufnahmenut mit seitlichen Ausläufen ist, wobei sich die Aufnahmenut mit seitlichen Ausläufen von dem elektrooptischen Element zur Gegenplatte erstreckt, insbesondere eine senkrecht zur der ersten Grundplattenebene und senkrecht zur entgegengesetzten zweiten Grundplattenebene verlaufende Aufnahmenut mit seitlichen Ausläufen ist. Es ist vorteilhaft, dass die Aufnahmenut mit seitlichen Ausläufen in einem Spritzguss-Verfahren integriert ist.

Gemäß einer ersten Ausgestaltungsform ist das Wärmeübertragungselement in die Aufnahme mittels Umspritzen in einem Spritzgussverfahren eingespritzt. Das hat den Vorteil, dass das Wärmeübertragungselement in einem Grundplatten-Herstellungsprozess integrierbar ist. Das eingespritzte Wärmeübertragungselement hat vorteilhafterweise eine H-Form, so dass eine Wärmeaufnahmefläche für die Wärmeaufnahme vom elektrooptischen Element und/oder eine Wärmeabführfläche für ein Wärmeabführen an die Gegenplatte des Wärmeübertragungselements maximiert ist. Das Wärmeübertragungselement H-förmig auszugestalten hat ferner den Vorteil, dass eine integrierte Leiterbahn für den Anschluss des elektrooptischen Elements an und/oder in seitliche Aussparungen des Wärmeübertragungselements integrierbar ist. Seitliche Aussparungen des Wärmeübertragungselements beschreibt die freie Fläche, die sich zwischen parallel verlaufenden Ausläufen des H-förmigen Wärmeübertragungselements bildet. Derart ist eine optimale Flächenausnutzung der Grundplatte ermöglicht, so dass eine minimal große Baugruppe realisierbar ist. Es ist aber auch denkbar eine I-Form, eine L-Form, eine T-Form oder eine andere denkbare Form für das Wärmeübertragungselement vorzusehen.

Gemäß einer alternativen Ausgestaltungsform ist das Wärmeübertragungselement in die Aufnahme eingepresst. Eine derartige Herstellung hat den Vorteil, dass das Wärmeübertragungselement nachträglich mechanisch einbaubar ist. Ein nachträgliches Einpressen des Wärmeübertragungselements in seine Aufnahme ist vorteilhaft, da es an individuelle Kühlbedingungen bezüglich der Ausgestaltungsform und/oder Materialzusammensetzung anpassbar ist. Ebenfalls denkbar ist es, nachträglich ein einstückig ausgebildetes Kühlbauteil einzupressen, wobei das Kühlbauteil sich aus dem Wärmeübertragungselement und der Gegenplatte zusammensetzt.

Ein erfindungsgemäßes Verfahren zum Herstellen einer Baugruppe aus einer Grundplatte und mindestens einem elektrooptischen Element, wobei die Grundplatte mit mindestens einer Leiterbahn für einen Anschluss des elektrooptischen Elements und mindestens einem Wärmeübertragungselement für eine Wärmeabführung von dem elektrooptischen Element versehen ist, enthält die folgenden Schritte:
- Bereitstellen der Grundplatte, wobei die Grundplatte aus einem LDS (Laser-Direkt-Strukturierung) -Material spritzgegossenen wird; und
   o das Wärmeübertragungselement im Spritzgussverfahren der Grundplatte (ebenfalls) umspritzt wird; oder
   o das Wärmeübertragungselement nach dem Spritzgussverfahren der Grundplatte eingepresst wird;
- Partielle Laseraktivierung/ Laserstrahlung der Grundplatte, so dass eine Ausnehmung für eine Leiterbahn ausgebildet ist;
- Beschichten/Metallisieren der Ausnehmung für die Leiterbahn, vorzugsweise wird für das Metallisieren eine Kupfer-, Nickel- oder Goldbeschichtung verwendet;
- Anbringen des elektrooptischen, wobei das Wärmeübertragungselement eine direkte wärmeleitende Wirkverbindung zwischen dem elektrooptischen Element und einem Metallteil gewährleistet, und wobei das MID-Bauteil eine Aufnahme für das Wärmeübertragungselement aufweist.

Bei dem LDS-fähigem Material, aus dem die Grundplatte hergestellt wird, kann es sich insbesondere um ein herkömmliches Kunststoffmaterial, beispielsweise PBT (Polybutylenterephthalat), handeln, dem ein Wirkstoffpartikel hinzugeführt ist. Der Wirkstoffpartikel ermöglicht zum einen eine Absorption von Strahlungsenergie und eine Umwandlung derselben in Wärmeenergie und zum anderen eine katalytische Wirkung bei der späteren Metallisierung. Derart ist in weiteren Schritten die gewünschte Leiterbahnstruktur herstellbar. Das Verfahren zur selektiven Herstellung einer Leiterbahnstruktur ist ausführlich in dem Dokument DE 10 2012 100 299 A1 beschrieben, dessen Offenbarungsgehalt hiermit durch Rückbezug aufgenommen wird.

Alternativ oder ergänzend ist es denkbar den Wirkstoffpartikel in eine für die Grundplatte vorgesehene Beschichtung, beispielswiese eine Pulverbeschichtung, beizumischen. Als Grundplatte dient hier eine aus Metall gebildete Grundplatte und/oder eine elektrisch leitfähige Kunststoff-Grundplatte. Als Material für die Metall-Grundplatte kann beispielsweise Stahl und/oder Aluminium verwendet werden. Die Grundplatte kann mittels des Metal Plated Implementation Verfahrens hergestellt sein, welches ausführlich in dem Dokument WO 2011/157515 A1 beschrieben ist und dessen Offenbarungsgehalt hiermit durch Rückbezug aufgenommen wird.

### Ausführungsbeispiel

Verschiedene Ausführungsformen der Erfindung werden nachfolgend unter Bezugnahme der Figuren 1 bis 3 näher erläutert. Es zeigen:
- Fig. 1 eine schematische Schnittansicht einer Baugruppe gemäß einer ersten Ausführungsform der Erfindung;
- Fig. 2 eine schematische Schnittdarstellung eines Ausschnittes aus der Baugruppe;
- Fig. 3 eine perspektivische Ansicht der Baugruppe gemäß einer weiteren Ausführungsform der Erfindung, und
- Fig. 4 eine perspektivische Ansicht von oben auf die Baugruppe gemäß einer weiteren Ausführungsform der Erfindung, sowie
- Fig. 5 eine perspektivische Ansicht von unten auf die Baugruppe gemäß der Ausführungsform nach Fig. 4.

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein.

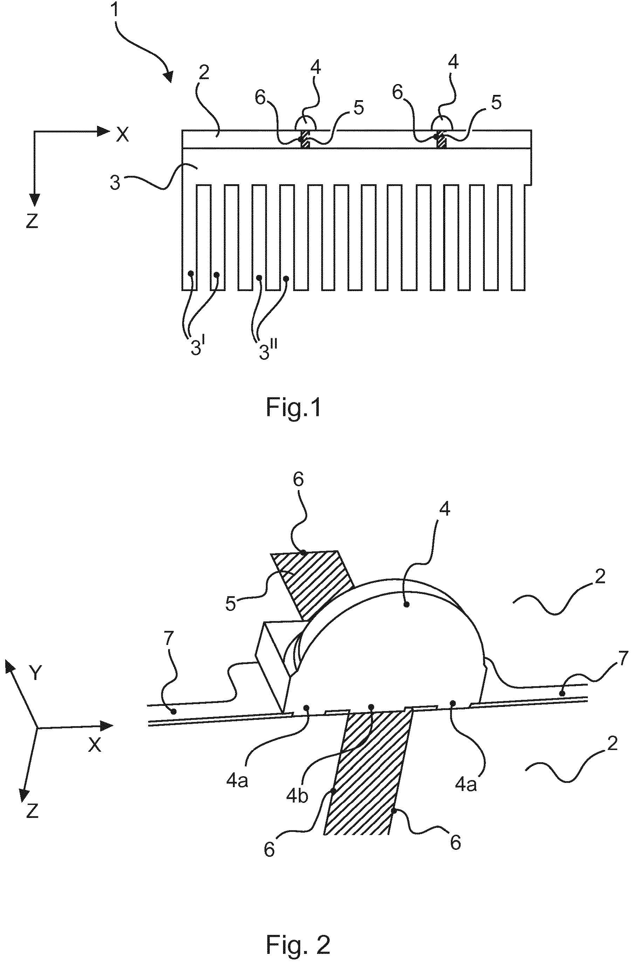

Die Fig. 1 zeigt schematisch eine Schnittdarstellung einer erfindungsgemäßen Baugruppe 1, bestehend aus einer Grundplatte 2, einer Gegenplatte 3, drei elektrooptischen Elementen 4 und jeweils drei Wärmeübertragungselementen 5 für ein Wärmeabführen vom jeweiligen elektrooptischen Element 4 zur Gegenplatte 3.

Die Grundplatte 2 ist in dieser Ausführung aus LDS-fähigem Material gebildet. In einer anderen Ausführung kann die Grundplatte 2 aus einem pulverbeschichteten Metall gebildet sein, wobei die Pulverbeschichtung ein LDSfähiges Additiv enthält.

Das elektrooptische Element 4 ist im vorliegenden Beispiel als LED ausgeführt, insbesondere als Hochleistungs-LED. Aber es sind hiermit auch andere Ausführungen offenbart, die weitere Leuchtmittel wie Glühbirnen verwenden.

Das Wärmeübertragungselement 5 ist in einer für das Wärmeübertragungselement 5 vorgesehenen Aufnahmenut 6 aufgenommen. Die Aufnahmenut 6 ist in der Grundplatte 2 eingeformt. Die Aufnahmenut 6 entspricht in seiner Erstreckung in z-Richtung einer Dicke der Grundplatte 2, so dass die Aufnahmenut 6 eine Aufnahmeöffnung ist, welche sich von einer ersten Grundplattenebene zur entgegengesetzten zweiten Grundplattenebene erstreckt.

Die Aufnahmenut 6 entspricht in seiner Erstreckung in x-Richtung wenigstens einer Breite des elektrooptischen Elements, bevorzugt einer geringeren Breite und besonders bevorzugt einem Drittel der Breite des elektrooptischen Elements.

Die Aufnahmenut 6 entspricht in seiner Erstreckung in y-Richtung zumindest einer Breite des elektrooptischen Elements in y-Richtung, bevorzugt einer größeren Breite des elektrooptischen Elements.

Das Wärmeübertragungselement 5 verläuft in seiner Aufnahmenut 6 senkrecht vom elektrooptischen Element 4 in z-Richtung zur Gegenplatte 3. Das Wärmeübertragungselement 5 entspricht in seiner Ausdehnung in z-Richtung zumindest der Dicke der Grundplatte 2, so, dass das Wärmeübertragungselement 5 sich von der ersten Grundplattenebene zur entgegengesetzten zweiten Grundplattenebene erstreckt und/oder durchgreift.

Das Wärmeübertragungselement kann in einem Ausführungsbeispiel ein aus wärmeleitfähigem Metall geformter Metallstift 5, insbesondere ein aus Messing geformter Metallstift 5 sein.

Die Gegenplatte 3 zeigt in der Fig. 1 Kühlrippen 3`, wobei die Kühlrippen Ausnehmungen 3" aufweisen. Derart ausgebildete Kühlrippen 3' weisen eine vergrößerte Oberfläche für eine optimierte Wärmeabfuhr aus der Gegenplatte 3 in die Umgebung auf. Eine solche Ausgestaltungsform erzielt zudem eine große Kühlfläche der Gegenplatte 3 bei einer kleinen Baugröße. Ein Wärmefluss ist in der Form realisiert, dass die am elektrooptischen Element produzierte Wärme über das Wärmeübertragungselement 5 aufgenommen und in z-Richtung an die kühlende Gegenplatte 3 abgeführt ist. Ein Wärmeaufstocken an einer wärmeempfindlichen Kunststoff-Grundplatte 2 ist derart verhindert und bleibt langlebend funktionsfähig.

Die Fig. 2 zeigt eine schematische Darstellung eines Ausschnittes aus der erfindungsgemäßen Baugruppe 1, wobei die Grundplatte 2, das elektrooptische Element 4, das Wärmeübertragungselement 5, die Aufnahme 6 für das Wärmeübertragungselement 5 sowie eine Leiterbahn 7 für einen Anschluss des elektrooptischen Elements 4 gezeigt sind.

Das elektrooptische Element 4 nach Fig.2 weist an seiner der Grundplatte zugewandten Seite zumindest einen Kontaktfuß 4a für ein Anschließen an die Leiterbahn 7 und zumindest einen Kontaktfuß 4b für ein Kontaktieren des Wärmeübertragungselements 5 auf. Der mindestens eine Kontaktfuß 4b des elektrooptischen Elements 4 und das Wärmeübertragungselement 5 stehen erfindungsgemäß in direktem Kontakt. Ein direkter Kontakt zwischen dem elektrooptischen Element 4 und dem Wärmeübertragungselement 5 hat in Versuchsreihen gezeigt, dass die produzierte Wärmemenge direkt an das Wärmeübertragungselement 5 abführbar ist. Folglich bleibt die Kunststoff-Grundplatte 2 frei von aufstauender Wärme und eine Deformation ist verhindert.

Das Wärmeübertragungselement 5 in seiner Aufnahmenut 6 entspricht in seiner Erstreckung in x-Richtung wenigstens einer Breite des elektrooptischen Elements 4, bevorzugt einer geringeren Breite und besonders bevorzugt zumindest der Breite des Kontaktfußes 4b des elektrooptischen Elements 4. Das Wärmeübertragungselement 5 in seiner Aufnahmenut 6 entspricht in seiner Erstreckung in y-Richtung zumindest einer Breite des elektrooptischen Elements 4 in y-Richtung, bevorzugt einer größeren Breite des elektrooptischen Elements. Eine über das elektrooptische Element 4 hinausragendes Wärmeübertragungselement in y-Richtung gewährleistet, dass insbesondere Hochleistungs-LEDs

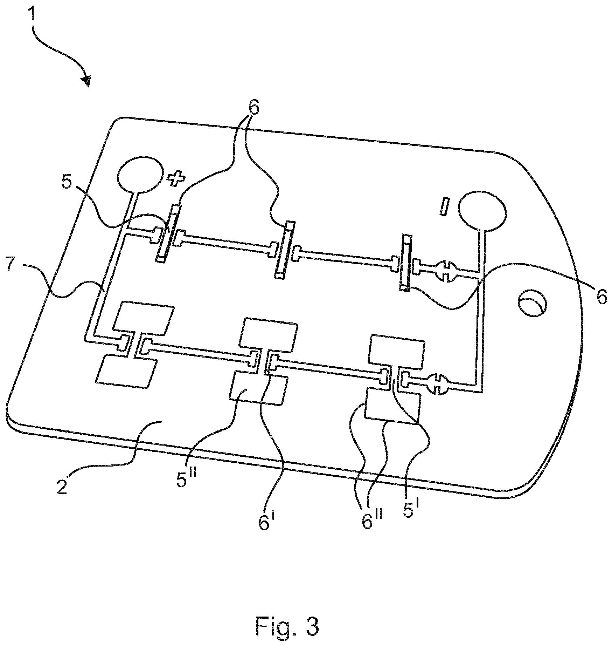

Die Fig. 3 zeigt eine perspektivische Ansicht der Baugruppe gemäß einer weiteren Ausführungsform der Erfindung, bestehend aus der Grundplatte 2, dem Wärmeübertragungselement 5 und einem weiteren Wärmeübertragungselement 5', 5". Ferner ist die Aufnahmenut 6 für das Wärmeübertragungselement 5 und eine weitere Aufnahmenut 6' mit seitlich entgegengesetzten Ausläufen 6" für das Wärmeübertragungselement 5', 5" dargestellt.

Das Wärmeübertragungselement 5 ist nach Fig. 3 ein nachträglich an das Spritzgussverfahren in seine Aufnahmenut 6 eingepresster Metallstift 5. Die Aufnahmenut 6 ist ein ebenfalls nachträglich an das Spritzgussverfahren ausgestanzte Aufnahmenut 6.

Das Wärmeübertragungselement 5', 5" ist in seine Aufnahmenut 6' mit seitlichen Ausläufen 6" mittels Umspritzen in einem Spritzgussverfahren eingespritzt. Nach Fig. 3 ist für das Wärmeübertragungselement eine H-förmige Ausgestaltung realisiert, wobei seine parallel zueinander ausgerichteten Erstreckungen 5" eine wesentlich größere Wärmeaufnahmefläche aufweisen im Vergleich zu seinem Verbindungsstift 5' für die parallel zueinander ausgerichteten Erstreckungen 5". Der verhältnismäßig dünne Verbindungsstift 5' ist bevorzugt für ein Kontaktieren mit dem elektrooptischen Element 4 vorgesehen, und besonders bevorzugt ist der Verbindungsstift 5' für ein Kontaktieren des Kontaktfußes 4b des elektrooptischen Elements 4 vorgesehen. Die am Verbindungsstift 5' aufgenommene Wärme vom elektrooptischen Element 4 wird über den Verbindungsstift 5' einerseits an seine endstellig angebundenen parallel zueinander ausgerichteten Erstreckungen 5" abgeleitet und andererseits direkt an die kühlende Gegenplatte 3 abgeleitet.

Eine H-förmige Wärmeaufnahmefläche am Wärmeübertragungselement 5`, 5" vorzusehen, bietet den Vorteil, dass eine große Kontaktfläche für ein schnelles und zuversichtliches Aufnehmen und anschließendes Ableiten der Wärme vom elektrooptischen Element 4 zur kühlenden Gegenplatte 3 realisiert ist. Die H-förmige Ausgestaltung des Wärmeübertragungselements 5', 5" erstreckt sich von einer Anschlussebene für das elektrooptische Element 4 der Grundplatte 2 zur entgegengesetzten Verbindungsebene für ein Anbinden mit der Gegenplatteneben der Grundplatte 2. Folglich ist eine H-förmige Wärmeabgabefläche zur Gegenplatte 3 am Wärmeübertragungselement 5', 5" vorgesehen.

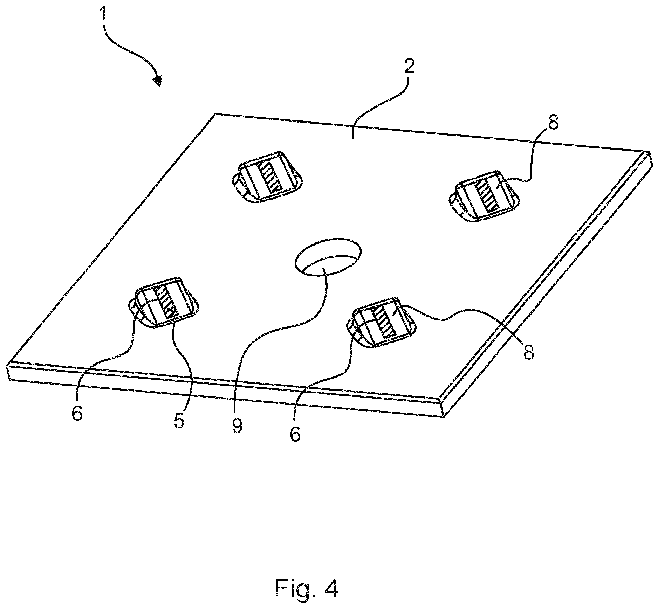

Die Fig. 4 zeigt eine erfindungsgemäße Baugruppe mit der Grundplatte 2 und dem Wärmeübertragungselement 5, wobei das Wärmeübertragungselement 5 als Metallstift 5 ausgebildet ist, und wobei die Leiterbahnen 7 nicht explizit dargestellt sind. Ferner ist mindestens eine Erhöhung 8, bevorzugt zwei bis vier Erhöhungen und besonders bevorzugt 64 bis 128 Erhöhungen auf einer Grundplatte 2, für ein Anbringen eines elektrooptischen Elementes 4 vorgesehen. Insbesondere sind die Erhöhungen 8 auf der Grundplatte 2 in einem geneigten Winkel zur ersten Grundplattenebene ausgerichtet. Die erste Grundplattenebene ist genau die Ebene, welche in Fig. 4 sichtbar dargestellt ist. Die geneigten Erhöhungen 8 und die Grundplatte 2 sind einstückig ausgebildet. Bevorzugt sind die Erhöhungen 8 in dem Spritzguss-Verfahren zur Herstellung der Grundplatte 2 gespritzt. Die Neigung der Erhöhungen 8 dient einem Ausrichten des elektrooptischen Elements 4, so dass je nach Anforderung der Ausrichtung des Lichtstrahls des elektrooptischen Elements 4, variierbare Neigungswinkel für die Erhöhungen 8 vorsehbar sind.

Bevorzugt beträgt der Neigungswinkel der Erhöhungen 8 für das Ausrichten der elektrooptischen Elemente 4 gemessen an der ersten Grundplattenebene 45°, besonders bevorzugt kleiner als 45° gemessen von der ersten Grundplattenebene.

Jeweils eine Aufnahmenut 6 für jeweils ein Wärmeübertragungselement 5 ist in der Grundplatte 2 vorgesehen. Die jeweils eine Aufnahmenut 6 ist vorteilhafterweise eine ausgestanzte Aufnahmenut 6. Die Aufnahmenut 6 erstreckt sich von jeweils einer Erhöhung 8 der Grundplatte 2 der ersten Grundplattenebene zur entgegengesetzt liegenden zweiten Grundplattenebene. Das jeweilige Wärmeübertragungselement 5 ist in seine Aufnahmenut 6 aufgenommen und erstreckt sich entsprechend in die Erhöhung 8. Derart ist das wärmeableitende Wärmeübertragungselement 5 genau am Anschlussbereich des elektrooptischen Elements 4 vorgesehen.

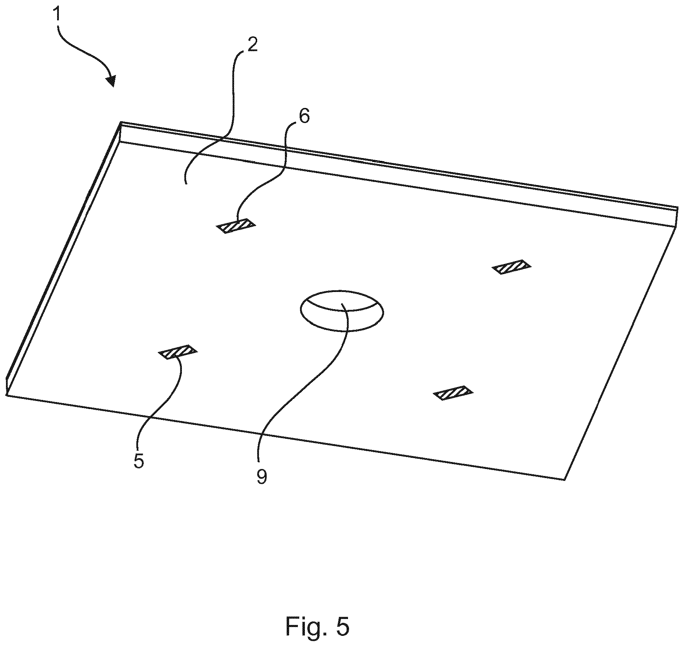

Insbesondere ist ein erstes Ende des Wärmeübertragungselements 5 geneigt ausgerichtet, und zwar dem Neigungswinkel der Erhöhung 8 auf der ersten Grundplattenebene entsprechend, und ein zweites Ende parallel zur gegenüberliegenden zweiten Grundplattenebene verlaufend ausgebildet. Das erste Ende des Wärmeübertragungselements 5 schließt also formschlüssig mit der geneigten Oberfläche der Erhöhung 8 ab und das zweite Ende des Wärmeübertragungselements 5 schließt formschlüssig mit der Oberfläche der entgegengesetzt liegenden zweiten Grundplattenebene ab (vgl. Fig. 4, Fig. 5).

Nach den Fig. 4 und Fig. 5 ist das Wärmeübertragungselement 5 ein ausgestanzter Metallstift 5. Der Metallstift 5 erstreckt sich dann von der geneigten Erhöhung 8 der Grundplattenebene einerseits zur gegenüberliegenden Grundplattenebene andererseits. Ferner ist der Metallstift 5 senkrecht zur ersten Grundplattenebene und senkrecht zur entgegengesetzt liegenden Grundplattenebene ausgerichtet.

Eine Befestigungsöffnung 9, wie in Fig. 4 dargestellt, dient einem Anbringen der erfindungsgemäßen Baugruppe an einem gewünschten Ort. Das vorliegende Ausführungsbeispiel sieht vor, die Baugruppe an einer Fixierstange anzubringen. Die Fixierstange ist bevorzugt aus einem wärmeleitfähigem Material ausgebildet, so dass die Fixierstange als Kühlkörper dient. Die am elektrooptischen Element 4 produzierte Wärme ist dann an die Fixierstange ableitbar und es ist keine weitere Gegenplatte 3 vorzusehen.

Bevorzugt ist die Grundplatte 2 eine aus Metall geformte Grundplatte 2, so, dass die Wärme über das Wärmeübertragungselement 5 aufnehmbar und über die Metall-Grundplatte 2 an die nicht dargestellte kühlende Fixierstange ableitbar ist. Weiter bevorzugt ist eine nicht dargestellte Wärmeleitpaste und/oder Wärmeleitfolie am Übergang von der Metall-Grundplatte 2 zur Fixierstange vorgesehen. Besonders bevorzugt füllt die Wärmeleitpaste und/oder Wärmeleitfolie Lufteinschlüsse vollständig aus, so dass ein formschlüssiges Fixieren der Grundplatte 2 an der Fixierstange ermöglicht ist. Das formschlüssige Fixieren hat den Vorteil, dass eine effiziente Wärmeableitung an die kühlende Fixierstange realisiert ist.

Es ist also klar, dass die erfindungsgemäße Baugruppe 1 an verschiedene geometrische Anforderungen kostengünstig anpassbar ist. Wenn beispielsweise am gewünschten Anbringungsort der Baugruppe eine kühlende Befestigungsmöglichkeit vorhanden ist, ist es sinnvoll auf eine Grundplatte 2 zu verzichten.

Die Fig. 5 zeigt eine perspektivische Ansicht der in Fig. 4 dargestellten Baugruppe 1 von unten, wobei die Grundplatte 2, das mindestens eine Wärmeübertragungselement 5 sowie die Befestigungsöffnung 9 für ein Befestigen der Baugruppe 1 an einer nicht dargestellten Fixierstange gezeigt sind. Die in Fig. 5 dargestellte Grundplatte 2 zeigt die zweite, zur ersten Grundplattenebene entgegengesetzt liegende, Grundplattenebene.

### Bezugszeichenliste

1 Baugruppe
2 MID-Bauteil, Grundplatte
3 Metallteil, Gegenplatte
3' Kühlrippen
3" Ausnehmungen
4 elektrooptisches Element
4a Kontaktfuß für ein Anschließen an Leiterbahn 7
4b Kontaktfuß für ein Kontaktieren des
   Wärmeübertragungselements 5
5 Wärmeübertragungselement oder Metallstift
5' Verbindungsstift
5" parallel zueinander ausgerichtete Erstreckungen
6 Aufnahmenut
7 Leiterbahn
8 Erhöhungen auf Grundplatte 2
9 Befestigungsöffnung

## Patentansprüche

1. Baugruppe (1) bestehend aus zumindest einem spritzgegossenen MID (Molded Interconnect Device)-Bauteil (2), einem damit verbundenen Metallteil (3) und einem elektrooptischen Element (4), wobei das MID-Bauteil (2) mit mindestens einer Leiterbahn (7) für einen Anschluss des elektrooptischen Elements (4) und mindestens einem Wärmeübertragungselement (5) für eine Wärmeabführung von dem elektrooptischen Element (4) versehen ist, wobei das Wärmeübertragungselement (5) eine direkte wärmeleitende Wirkverbindung zwischen dem elektrooptischen Element (4) und dem Metallteil (3) ist und das MID-Bauteil (2) eine Aufnahme (6) für das Wärmeübertragungselement (5) vorsieht.

2. Baugruppe (1) nach Anspruch 1, wobei das MID-Bauteil (2) aus einem Kunststoffmaterial gebildet ist.

3. Baugruppe (1) nach einem der vorstehenden Ansprüche, wobei das spritzgegossene MID-Bauteil im LDS (Laser-Direkt-Strukturierung)-Verfahren hergestellt ist.

4. Baugruppe (1) nach einem der vorstehenden Ansprüche, wobei , das Metallteil (3) ein Kühlkörper (3) ist.

5. Baugruppe (1) nach einem der vorstehenden Ansprüche, wobei das Metallteil (3) aus einem Wärmeleiter-Material ausgebildet ist.

6. Baugruppe (1) nach einem der vorstehenden Ansprüche, wobei das Wärmeübertragungselement (5) einen Metalleinsatz insbesondere einen Metallstift (5), umfasst.

7. Baugruppe (1) nach einem der vorhergehenden Ansprüche, wobei das spritzgegossene MID-Bauteil eine Grundplatte (2) mit einer Grundplattenebene ist, und dass es sich bei dem Metallteil um eine Gegenplatte (3) handelt.

8. Baugruppe (1) nach Anspruch 7, wobei die Aufnahme (6) für das Wärmeübertragungselement (5) eine Aufnahmenut (6) umfasst, welche sich von dem elektrooptischen Element (4) zur Gegenplatte (3) erstreckt, insbesondere eine zu einer Grundplattenebene senkrecht verlaufende Aufnahmenut (6).

9. Baugruppe (1) nach einem der vorhergehenden Ansprüche, wobei das Wärmeübertragungselement (5) in die Aufnahme (6) mittels Umspritzen in einem Spritzgussverfahren eingespritzt ist.

10. Baugruppe (1) nach einem der vorhergehenden Ansprüche, wobei das Wärmeübertragungselement (5) in die Aufnahme (6) eingepresst ist.

11. Verfahren zum Herstellen einer Baugruppe nach einem der Ansprüche 1 bis 10, enthaltend folgende Schritte:
- Bereitstellen eines MID-Bauteils (2), wobei das MID-Bauteil (2) aus einem LDS-Material (Laser-Direkt-Strukturierung) spritzgegossenen wird, und wobei
o ein Wärmeübertragungselement (5) im Spritzgussverfahren des MID-Bauteils (2) umspritzt wird; oder
o ein Wärmeübertragungselement (5) nach dem Spritzgussverfahren des MID-Bauteils (2) eingepresst wird;
- Partielle Laseraktivierung/ Laserstrahlung des MID-Bauteils (2), so dass eine Ausnehmung für die Leiterbahn (7) ausgebildet wird;
- Beschichten/Metallisieren der Ausnehmung für die Leiterbahn (7), wobei vorzugsweise für das Metallisieren eine Kupfer-, Nickel- oder Goldbeschichtung verwendet wird;
- Anbringen des elektrooptischen Elements (4) an dem MID-Bauteil, wobei das Wärmeübertragungselement (5) eine direkte wärmeleitende Wirkverbindung zwischen dem elektrooptischen Element (4) und dem Metallteil (3) gewährleistet, und wobei das MID-Bauteil (2) eine Aufnahme (6) für das Wärmeübertragungselement (5) aufweist.

## Claims

1. An assembly (1) consisting of at least one injection-molded MID (Molded Interconnect Device) component (2), a metal part (3) connected thereto, and an electro-optical element (4), the MID component (2) being provided with at least one conductor path (7) for a connection of the electro-optical element (4) and at least one heat transfer element (5) for a heat dissipation from the electro-optical element (4), wherein the heat transfer element (5) is a direct heat-conducting operative connection between the electro-optical element (4) and the metal part (3) and the MID component (2) provides a retainer (6) for the heat transfer element (5).

2. The assembly (1) according to claim 1, wherein the MID component (2) is formed from a plastic material.

3. The assembly (1) according to either of the preceding claims, wherein the injection-molded MID component is manufactured using the LDS (laser direct structuring) method.

4. The assembly (1) according to any of the preceding claims, wherein the metal part (3) is a heat sink (3).

5. The assembly (1) according to any of the preceding claims, wherein the metal part (3) is formed of a heat conductor material.

6. The assembly (1) according to any of the preceding claims, wherein the heat transfer element (5) comprises a metal insert, in particular a metal pin (5).

7. The assembly (1) according to any of the preceding claims, wherein the injection-molded MID component is a base plate (2) having a base plate plane and the metal part is a counter plate (3).

8. The assembly (1) according to claim 7, wherein the retainer (6) for the heat transfer element (5) comprises a receiving groove (6) which extends from the electro-optical element (4) to the counter plate (3), in particular a receiving groove (6) extending perpendicularly to a base plate plane.

9. The assembly (1) according to any of the preceding claims, wherein the heat transfer element (5) is injected into the retainer (6) by means of overmolding in an injection molding process.

10. The assembly (1) according to any of the preceding claims, wherein the heat transfer element (5) is pressed into the retainer (6).

11. A method of manufacturing an assembly according to any of claims 1 to 10, comprising the following steps:
- providing an MID component (2), the MID component (2) being injection-molded from an LDS material (laser direct structuring), and wherein
o a heat transfer element (5) is overmolded in the process of injection molding the MID component (2); or
o a heat transfer element (5) is pressed in after the process of injection molding the MID component (2);
- partial laser activation/laser irradiation of the MID component (2), so that a recess for the conductor path (7) is formed;
- plating/metallizing the recess for the conductor path (7), wherein a copper, nickel or gold plating is preferably used for the metallizing process;
- attaching the electro-optical element (4) to the MID component,
wherein the heat transfer element (5) ensures a direct heat-conducting operative connection between the electro-optical element (4) and the metal part (3) and wherein the MID component (2) includes a retainer (6) for the heat transfer element (5).

## Revendications

1. Ensemble (1) composé d'au moins un composant (2) MID (Molded Interconnect Device) moulé par injection, d'une pièce métallique (3) reliée à celuici, et d'un élément électro-optique (4), le composant MID (2) étant pourvu d'au moins une piste conductrice (7) pour un raccordement de l'élément électro-optique (4) et d'au moins un élément de transfert de chaleur (5) pour une dissipation de chaleur de l'élément électro-optique (4), l'élément de transfert de chaleur (5) étant une liaison fonctionnelle directe thermoconductrice entre l'élément électro-optique (4) et la pièce métallique (3), et le composant MID (2) prévoyant un logement (6) pour l'élément de transfert de chaleur (5).

2. Ensemble (1) selon la revendication 1, le composant MID (2) étant réalisé en un matériau plastique.

3. Ensemble (1) selon l'une des revendications précédentes, le composant MID moulé par injection étant réalisé selon le procédé LDS (structuration directe par laser).

4. Ensemble (1) selon l'une des revendications précédentes, la pièce métallique (3) étant un corps de refroidissement (3).

5. Ensemble (1) selon l'une des revendications précédentes, la pièce métallique (3) étant réalisée en un matériau thermoconducteur.

6. Ensemble (1) selon l'une des revendications précédentes, l'élément de transfert de chaleur (5) comprenant un insert métallique, en particulier une goupille métallique (5).

7. Ensemble (1) selon l'une des revendications précédentes, le composant MID moulé par injection étant une plaque de base (2) avec un plan de plaque de base, et la pièce métallique étant une contreplaque (3).

8. Ensemble (1) selon la revendication 7, le logement (6) pour l'élément de transfert de chaleur (5) comprenant une rainure de logement (6) qui s'étend de l'élément électro-optique (4) à la contreplaque (3), en particulier une rainure de logement (6) s'étendant perpendiculairement à un plan de la plaque de base.

9. Ensemble (1) selon l'une des revendications précédentes, l'élément de transfert de chaleur (5) étant injecté dans le logement (6) par enrobage par injection selon un procédé de moulage par injection.

10. Ensemble (1) selon l'une des revendications précédentes, l'élément de transfert de chaleur (5) étant enfoncé dans le logement (6).

11. Procédé de fabrication d'un ensemble selon l'une des revendications 1 à 10, comprenant les étapes suivantes :
- le fournissement d'un composant MID (2), le composant MID (2) étant moulé par injection à partir d'un matériau LDS (structuration directe par laser), et
∘ un élément de transfert de chaleur (5) étant enrobé par injection lors du procédé de moulage par injection du composant MID (2) ; ou
∘ un élément de transfert de chaleur (5) étant enfoncé après le procédé de moulage par injection du composant MID (2) ;
- l'activation au laser partielle/le rayonnement au laser partiel du composant MID (2) de sorte qu'un évidement est réalisé pour la piste conductrice (7) ;
- le revêtement/la métallisation de l'évidement pour la piste conductrice (7), un revêtement de cuivre, de nickel ou d'or étant de préférence utilisé pour la métallisation ;
- la mise en place de l'élément électro-optique (4) sur le composant MID, l'élément de transfert de chaleur (5) assurant une liaison fonctionnelle directe thermoconductrice entre l'élément électro-optique (4) et la pièce métallique (3), et le composant MID (2) présentant un logement (6) pour l'élément de transfert de chaleur (5).
